# EUROPEAN PATENT SPECIFICATION

(11) **EP 1 229 068 B1**
(45) Date of publication and mention of the grant of the patent: **14.09.2005**
(21) Application number: 02002554.0
(22) Date of filing: 04.02.2002
(51) Int. Cl.: C08J 7/00, H01J 37/32, B65D 1/00, C23C 16/00

(54) **Method and apparatus for modifying the inner surface of containers made of polymeric compound**
Verfahren und Vorrichtung zum Modifizieren der inneren Oberfläche von Behältern aus Kunststoff
Méthode et dispositif pour modifier la surface intérieure de récipients en plastique

(30) Priority: 06.02.2001 JP 2001029176
(43) Date of publication of application: 07.08.2002
(73) Proprietor: SHIBUYA KOGYO CO., LTD., Ishikawa 920-8681 (JP); KANAZAWA INSTITUTE OF TECHNOLOGY, Ishikawa (JP)
(72) Inventor: Ikenaga, Noriaki c/o Shibuya Kogyo Co., Ltd., Kanazawa-shi Ishikawa 920-8681 (JP); Sakudo, Noriyuki, Kanazawa-shi, Ishikawa (JP)
(74) Representative: Grünecker, Kinkeldey, Stockmair & Schwanhäusser Anwaltssozietät

(56) References cited:
- EP-A- 0 773 166
- WO-A-95/22413
- WO-A-99/17334
- US-A- 6 001 429
- US-A- 6 112 695

## Description

The present invention relates to a method and apparatus for modifying the surface of a container made of a polymeric compound, and more particularly relates to a method and apparatus for modifying the interior side surface of, for example, a PET (polyethylene terephthalate) container into a material having low permeability to gases, such as DLC (diamond-like carbon), according to the generic parts of claim 1 and 4.

Such a method and apparatus are known from EP 0773166 A1, wherein a carbon film-coated plastic container is obtained by forming a diamond-like carbon film on an inner surface of a container. Similar methods and apparatus are also known from US 6112695, WO 95/22413, WO 99/17334 and US 6001429.

In recent years, PET containers are often used as containers for beverages because of their light weight, impact-resistance and resealability.

Despite such features, the PET containers had a defect that they were permeated by oxygen and carbon dioxide. Accordingly, the PET containers were inadequate for use as containers filled with beer or carbonated beverages. Thus, the PET containers had a defect that they could not be used as containers for such beverages.

Therefore, in the related art, apparatus and a method for coating the inner surface of a PET container with a hard carbon film has been proposed to solve the defect of the PET container (for example, Japanese Patent No. 2788412).

According to the apparatus and the method disclosed in the patent, only the inner surface of a PET container can be coated with a hard carbon film so that permeation of oxygen or carbon dioxide can be blocked by the hard carbon film.

However, in the apparatus and the method disclosed in the patent, carbon-based gas as a raw material for the hard carbon film was supplied into the PET container, and plasma was then generated to make the carbon-based gas adhere to the interior side surface of the container so as to form the hard carbon film. In other words, the apparatus and the method disclosed in the patent was only a technique for coating the interior side surface of the container with the hard carbon film without modifying the interior side surface of the container itself.

Accordingly, when the PET container manufactured by the apparatus and the method disclosed in the patent was filled with a beverage, there was a fear that the hard carbon film with which the container was coated might peel off and get mixed into the beverage. Thus, there was a defect that the PET container was short of reliability as a container for beverage.

### SUMMARY OF THE INVENTION

It is therefore an object of the invention to provide a container in which permeation of oxygen and carbon dioxide can be prevented or made difficult, while there is no fear that the interior side surface of the container peels off after the container is filled with a beverage.

That is, according to the invention, there is provided a method for modifying a surface of a container made of a polymeric compound containing carbon, including the step of: implanting ions into the container so as to modify a surface layer of the container into a material that is not permeable by carbon dioxide gas and oxygen or a material that is hard to be permeated by carbon dioxide gas and oxygen.

Further, according to the invention, there is provided apparatus for modifying a surface of a container made of a polymeric compound including: a reception chamber which can receive the container while keeping airtightness; a vacuum pump for evacuating the reception chamber; a plasma generating unit for generating plasma in the reception chamber; an electrode inserted into the container received in the reception chamber; and a high voltage power source for applying high voltage pulses to the electrode; wherein an interior side surface layer of the container received in the reception chamber is modified into a material that is not permeable by carbon dioxide gas and oxygen or a material that is hard to be permeated by carbon dioxide gas and oxygen.

With such a configuration, the surface layer of the container made of a polymeric compound can be modified into a material that is not permeable by carbon dioxide gas and oxygen or a material that is hard to be permeated by carbon dioxide gas and oxygen. Thus, it is possible to provide a polymeric compound container which is not permeated or is hard to be permeated by carbon dioxide gas or oxygen. In addition, because the surface layer of the container itself is modified, there is no fear that the modified surface layer peels off.

Accordingly, it is possible to provide a polymeric compound container suitable for beer or carbonated beverage.

Features and advantages of the invention will be evident from the following detailed description of the preferred embodiments described in conjunction with the attached drawings.

### BRIEF DESCRIPTION OF THE DRAWINGS

In the accompanying drawings:
Fig. 1 is a sectional view showing a first embodiment of the invention;
Fig. 2 is a sectional view showing the first embodiment of the invention;
Fig. 3 is an end view showing another state of a main portion shown in Fig. 2;
Fig. 4 is a sectional view of a main portion of a PET container showing the state of the surface which has not yet been modified by the apparatus shown in Fig. 1 and the state of the surface which has been modified;
Fig. 5 is a sectional view showing a third embodiment of the invention;
Fig. 6 is a sectional view of a main portion taken on line VI-VI in Fig. 5;
Fig. 7 is a sectional view showing a fourth embodiment of the invention;
Fig. 8 is a sectional view showing a fifth embodiment of the invention;
Fig. 9 is a sectional view of the fifth embodiment showing a state different from that in Fig. 8;
Fig. 10 is a sectional view showing a sixth embodiment of the invention; and
Fig. 11 is a sectional view of a main portion taken on line X-X in Fig. 10.

### DETAILED DESCRIPTION OF THE PREFERRED EMBODIMENTS

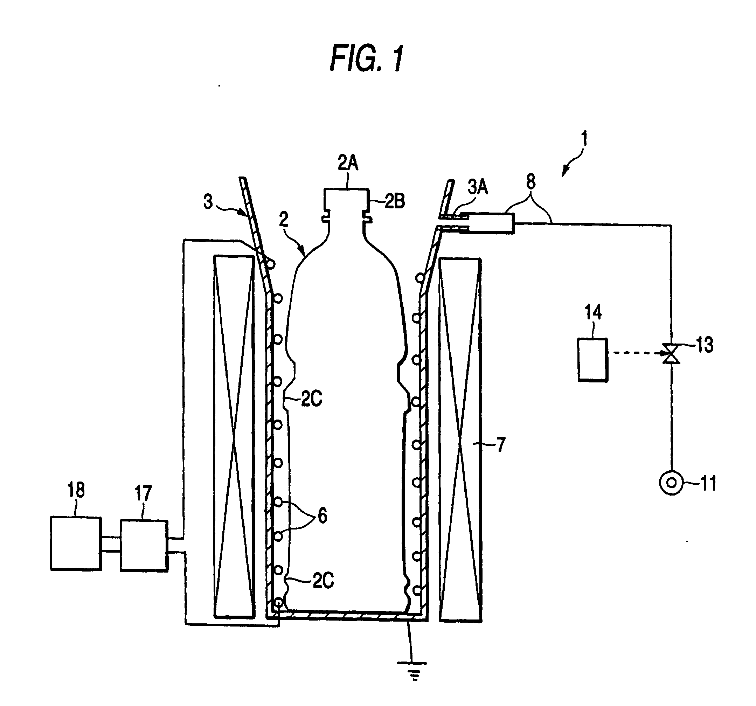

The invention will be described below with respect to its embodiments shown in the drawings. In Figs. 1 to 3, a modifying apparatus 1 modifies the interior side surface of a PET container 2.

This modifying apparatus 1 has a cup-like reception chamber 3 which can receive the PET container 2, a cover 4 for closing a top opening of the reception chamber 3, a tube-like electrode 5 provided in the cover 4, a coil 6 disposed in an inner circumferential portion of the reception chamber 3, and a solenoid coil 7 disposed to surround the reception chamber 3 and the coil 6.

The PET container 2 having a surface which will be modified by the modifying apparatus 1 has an opening portion 2A at its top, and a threaded portion 2B in the outer circumferential portion of the top. A not-shown cap is screwed to the threaded portion 2B. The PET container 2 is transparent and colorless, and a plurality of annular projections 2C are formed at required places of its body for the purpose of reinforcement. That is, the PET container 2 having a surface which will be modified by the modifying apparatus 1 is a general PET container known in the related art, and is designed so that liquid such as beverage is filled into the inside of the PET container 2 through the opening portion 2A. The PET container 2 configured thus is supplied into the reception chamber 3 so that the opening portion 2A faces upward.

The reception chamber 3 is made of a conductive material and formed into a cup-like shape with a wide mouth in the top portion. A suction port 3A is formed in a position close to the top portion.

One end of a conduit 8 is connected to the suction port 3A while the other end of the conduit 8 is connected to a vacuum pump 11. A normally closed electromagnetic on-off valve 13 is provided in the middle of the conduit 8. The operation of the electromagnetic on-off valve 13 is controlled by a control unit 14.

When the electromagnetic on-off valve 13 is opened by the control unit 14, the reception chamber 3 is evacuated through the conduit 8 and the suction port 3A. Incidentally, the reception chamber 3 made of a conductive material is electrically connected to a constant voltage body such as the ground.

Next, the cover 4 is made of a conductive material formed into a disc-like shape. The cover 4 can be moved up and down above the reception chamber 3 by a not-shown elevating mechanism. A through hole 4A is formed at a center portion of the cover 4. A support portion 5Aof the electrode 5 penetrates the through hole 4A slidably while keeping airtightness. The support portion 5A is formed out of a cylindrical insulating material, and fitted in a predetermined position of the electrode 5. Incidentally, an annular seal member 29 is planted in the outer circumferential portion of the lower surface of the cover 4. Thus, when the cover 4 is mounted on the top opening portion of the reception chamber 3 to thereby close the reception chamber 3, airtightness is kept between the top opening portion of the reception chamber 3 and the cover 4.

The electrode 5 is made of a conductive pipe, and electrically connected to a DC high voltage power source 15. The upper end portion of the electrode 5 is made to project over the upper surface of the cover 4. One end of a conduit 16 is connected to the upper end portion of the electrode 5. The other end of the conduit 16 is connected to a gas supply source 12. In this embodiment, argon gas is reserved in the gas supply source 12. Anormally closed electromagnetic on-off valve 21 is provided in the middle of the conduit 16. The operation of the electromagnetic on-off valve 21 is also controlled by the control unit 14. When the electromagnetic on-off valve 21 is opened by the control unit 14, argon gas is supplied into the reception chamber 3 from the supply source 12 through the conduit 16. In such a manner, the electrode 5 also serves as a gas introduction tube in this embodiment.

As will be described later, the PET container 2 is received in the reception chamber 3 by a not-shown conveying mechanism in the state where the cover 4 is located in its rising limit position apart from the top of the reception chamber 3 by the elevating mechanism. After that, the cover 4 is moved down to its falling limit position by the elevating mechanism so that the electrode 5 is inserted into the container 2 in the reception chamber 3. After that, the cover 4 is mounted on the top portion of the reception chamber 3 so as to close the top opening portion of the reception chamber 3. In this airtight state, the reception chamber 3 is evacuated through the conduit 8, and argon gas is then supplied to the whole area of the internal space of the reception chamber 3 including the internal space of the PET container 2 through the conduit 16 and the electrode 5.

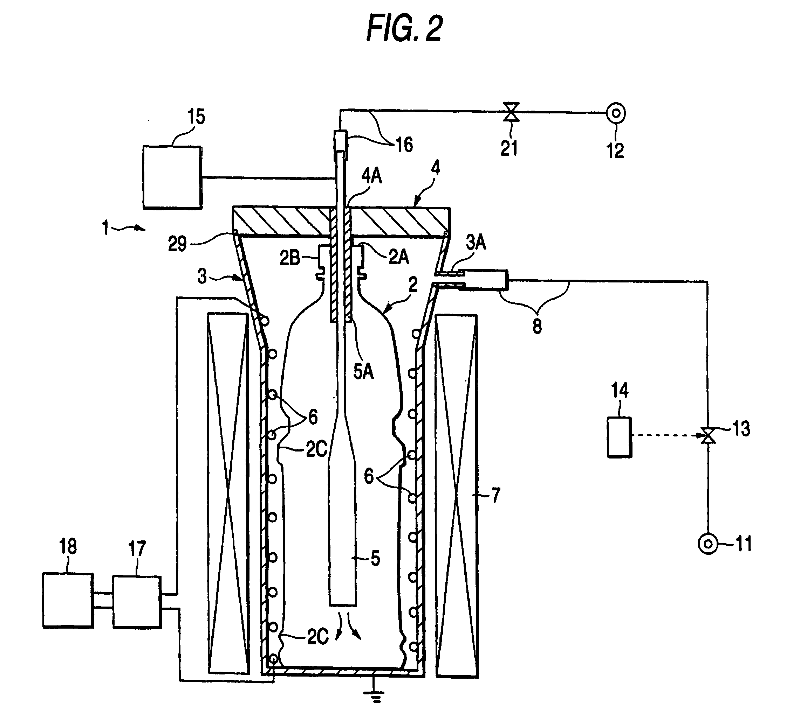

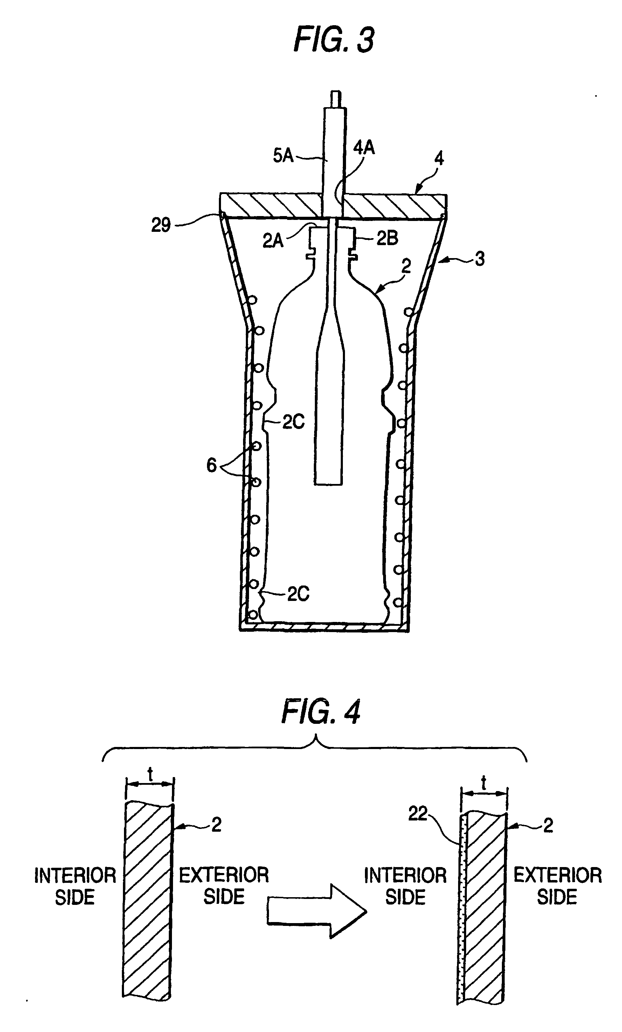

In addition, as shown in Fig. 2, in the state where the top opening of the reception chamber 3 is closed by the cover 4, the support portion 5A of the electrode 5 is located on the interior side of the top opening portion 2A and the threaded portion 2B of the PET container 2. In this state, the electrode 5 itself can be further lifted up by a predetermined distance relatively to the cover 4 by the elevating mechanism (Fig. 3). In this state of Fig. 3, the support portion 5A made of an insulating material is located above the top opening portion 2A of the PET container 2.

The operation of the DC high voltage power source 15 connected to the electrode 5 is controlled by the control unit 14. The high voltage power source 15 is designed to apply positive high voltage pulses to the electrode 5 when an operating instruction is transmitted from the control unit 14 to the high voltage power source 15.

Next, the coil 6 provided in the inner circumferential portion of the reception chamber 3 is electrically insulated from the reception chamber 3. The coil 6 is connected to a high frequency power source 18 ranging from several of MHz to several hundreds of MHz through a matching circuit 17 disposed outside the reception chamber 3. The operation of the high frequency power source 18 is also controlled by the control unit 14. The high frequency power source 18 is designed to apply a high frequency current ranging from several of MHz to several hundreds of MHz to the coil 6 when an operating instruction is transmitted from the control unit 14 to the high frequency power source 18.

Further, the solenoid coil 7 disposed to surround the reception chamber 3 is connected to a not-shown power source. When an operating instruction is transmitted from the control unit 14 to the power source, the solenoid coil 7 is excited to generate a DC magnetic field.

In this embodiment, a plasma generating unit for generating plasma is constituted by the coil 6, the matching circuit 17 and the high frequency power source 18.

### ---(Description of Operation)

In the configuration described above, the interior side surface of the PET container 2 is modified through the following process by the modifying apparatus 1.

That is, when the PET container 2 has not yet been received in the reception chamber 3, the cover 4 is retained in its rising limit position apart from and above the top portion of the reception chamber 3 by a not-shown elevating mechanism. In this state, the PET container 2 is conveyed to a position above the reception chamber 3 by a not-shown conveying mechanism and then received in the reception chamber 3 (Fig. 1).

Next, the cover 4 is moved down to its falling limit position by the elevating mechanism. Thus, the electrode 5 is inserted into the PET container 2 through the opening portion 2A while the top opening portion of the reception chamber 3 is made airtight by the cover 4 (Fig. 2).

Next, the control unit 14 switches the power source for the solenoid coil 7 so as to make a current flow into the solenoid coil 7 and thereby excite the solenoid coil 7. Thus, a magnetic field is generated all over the internal space of the reception chamber 3 receiving the PET container 2.

Next, the control unit 14 opens the electromagnetic on-off valve 13 for a predetermined period of time. Thus, the reception chamber 3 is evacuated through the conduit 8 so that the pressure in the internal space of the reception chamber 3 becomes lower than the atmospheric pressure.

Next, in this state, the control unit 14 opens the electromagnetic on-off valve 21 provided in the conduit 16 for a predetermined period of time. Thus, argon gas is introduced into the internal space of the PET container 2 through the conduit 16. That is, the argon gas intervenes between the spaces inside and outside the PET container 2 in the reception chamber 3.

After that, the control unit 14 transmits an operating instruction to the high frequency power source 18 so that a high frequency current ranging from several of MHz to several hundreds of MHz is applied from the high frequency power source to the coil 6. Thus, plasma is generated in the reception chamber 3.

Further, in this state, the control unit 14 transmits an operating instruction to the high voltage power source 15 so that a series of positive high voltage pulses are applied from the high voltage power source 15 to the electrode 5. Thus, ions of the plasma interior the PET container 2 are implanted into its interior side surface.

Here, because the PET container 2 is an insulator, the surface potential increases due to the ion charge-up during ion implantation. However, the surface is exposed to the plasma during the pause of the pulse. Thus, the surface is neutralized to recover its original potential. Then, ion implantation is carried out again until the next pulse.

Next, in this state, the electrode 5 is moved up by a predetermined height relatively to the cover 4 by the elevating mechanism (Fig. 3). Then, high voltage pulses are applied to carry out ion implantation again. Accordingly, the support portion 5A of the electrode 5 is supported above the top portion of the PET container 2. Thus, ions are also implanted surely into the interior side surface of the threaded portion 2B where the support portion 5A had been located.

In this embodiment, ions are implanted thus into the whole area of the interior side surface of the PET container 2. Accordingly, the material itself of the interior side surface of the PET container 2 originally containing carbon are modified into DLC (diamond-like carbon) throughout (see Fig. 4). That is, in this embodiment, the original surface of the PET container 2 is not coated with DLC but the material itself of the surface of the PET container 2 is modified into DLC so that a DLC layer 22 is formed all over the interior side surface as shown on the right of Fig. 4.

Incidentally, in the work process, the electrode 5 does not always have to be moved up to the position in Fig. 3 from the position in Fig. 2 after ion implantation.

When the work of modifying the surface of one PET container 2 is completed in such a manner, the cover 4 is moved up to its rising limit position by the elevating mechanism so as to open the reception chamber 3 and extract the electrode 5 from the PET container 2. Incidentally, it is preferable that the cover 4 is not moved up directly in the state where the reception chamber 3 is closed, but moved up by the elevating mechanism after the reception chamber 3 is once made open to the atmosphere through the conduit 8.

After that, the PET container 2 subjected to the treatment is extracted by a not-shown extracting mechanism, while a new PET container 2 is received in the reception chamber 3. Then, the interior side surface of the new PET container 2 is modified into a DLC layer 22 in the process described above.

As has been described above, in this embodiment, the whole area of the interior side surface of the PET container 2 is modified into the DLC layer 22. Accordingly, it is possible to provide the PET container 2 which is transparent and colorless or slightly colored and which can prevent the permeation of carbon dioxide gas and oxygen or is hard to be permeated by carbon dioxide gas and oxygen. It is therefore possible to provide the PET container 2 which is suitable not only as a container for general beverages such as mineral water but also a container for carbonated beverages such as beer.

In addition, unlike the related art in which a DLC film is deposited on the interior side surface of a container 2 so that the interior side surface is coated with the DLC film, in this embodiment, the material itself of the interior side surface of the PET container 2 is modified into DLC. Thus, there is no fear that the DLC layer 22 peels off. Accordingly, after liquid such as a beverage is filled up into the PET container 2, there is no fear that pieces of peeled DLC are mixed into the liquid. It is possible to provide a safe container for beverage use.

Further, the period of time required for forming the DLC layer 22 in the interior side surface of the PET container 2 in this embodiment is one over several parts in the related-art technique in which the surface is coated with a DLC film. It is therefore possible to provide the modifying apparatus 1 and the modifying method fast in treatment speed.

In addition, the PET container 2 having an interior side surface which has been modified according to this embodiment can be recycled throughout. Incidentally, although description in this embodiment has been made on the case where argon gas reserved in the gas supply source 12 is supplied into the reception chamber 3, hydrocarbon gas or nitrogen gas may be used in place of the argon gas.

### --- (Second Embodiment)

Next, though not illustrated, the following configuration may be adopted as a second embodiment of the modifying apparatus 1. That is, the gas supply source 12, the conduit 16 and the electromagnetic on-off valve 21 in the first embodiment shown in Figs. 1 to 3 may be omitted in the second embodiment, while the others are arranged similarly to those in the first embodiment. Incidentally, in the second embodiment, not a pipe-like one but a rod-like one is used as the electrode 5 . In this second embodiment, a plasma generating unit for generating plasma is constituted by the coil 6, the matching circuit 17 and the high frequency power source 18. In such a modifying apparatus 1 according to the second embodiment, treatment is carried out in the following process.

That is, while the cover 4 and the electrode 5 are retained in their rising limit positions by an elevating mechanism, the PET container 2 is conveyed to a position above the reception chamber 3 by a not-shown conveying mechanism, and then received in the reception chamber 3.

Next, the cover 4 is moved down to its falling limit position by the elevating mechanism. Thus, the electrode 5 is inserted into the PET container 2 while the top opening portion of the reception chamber 3 is closed by the cover 4.

At the same time, the control unit 14 switches the power source for the solenoid coil 7 so as to make a current flow into the solenoid coil 7 to thereby excite the solenoid coil 7. Thus, a magnetic field is generated in the reception chamber 3.

After that, the control unit 14 opens the electromagnetic on-off valve 13 for a predetermined period of time. Thus, the reception chamber 3 is evacuated.

After that, the control unit 14 transmits an operating instruction to the high frequency power source 18 so that a high frequency current ranging from several of MHz to several hundreds of MHz is applied from the high frequency power source to the coil 6. Thus, plasma is generated in the reception chamber 3.

Further, in this state, the control unit 14 transmits an operating instruction to the high voltage power source 15 so that positive high voltage pulses are applied from the high voltage power source 15 to the electrode 5. Thus, ions of the plasma inside the PET container 2 are implanted into the PET container 2 from its interior side surface.

Thus, the whole area of the interior side surface of the PET container 2 is modified into a DCL layer 22.

Also in the second embodiment configured thus, it is possible to obtain functions and effects similar to those in the first embodiment.

### --- (Third Embodiment)

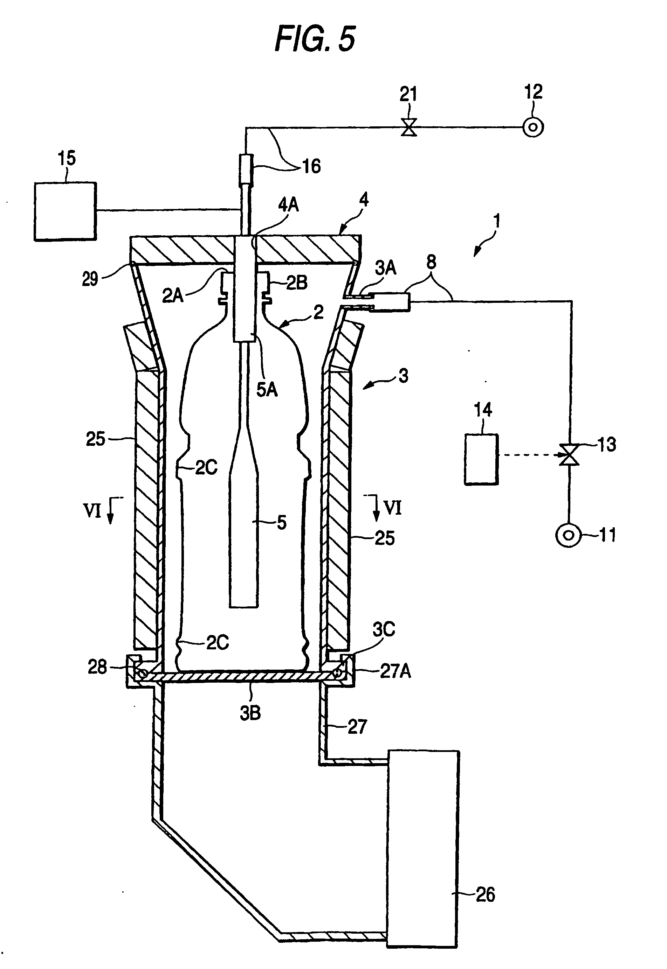

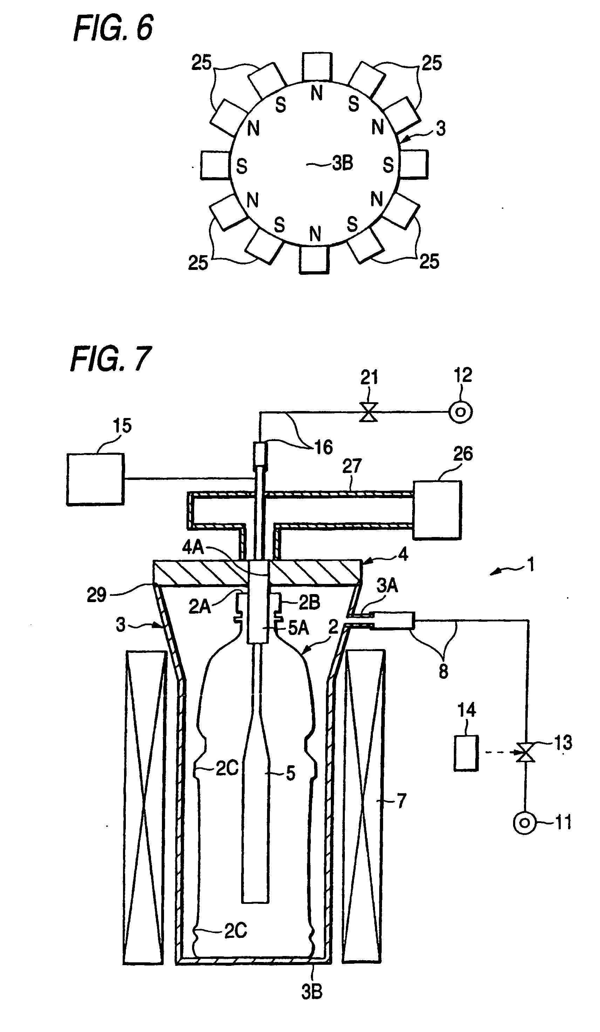

Next, Figs. 5 and 6 show a third embodiment of the invention. In brief, in this third embodiment, a plurality of permanent magnets 25 are used in place of the solenoid coil 7 in the first embodiment, and a magnetron 26 is used in place of the coil 6, the matching circuit 17 and the high frequency power source 18 likewise.

That is, in the reception chamber 3 in the third embodiment, a flange portion 3C is formed in a bottom outer circumferential portion of a cylindrical body portion. A quartz sheet is superposed on the lower surface of the flange portion 3C. A bottom surface 3B of the reception chamber 3 is constituted by the quartz sheet. In addition, in this state, a flange-like connection portion 27A formed on the side of a waveguide 27 is fitted to the outer circumferential portions of the quartz sheet (bottom surface 3B) and the flange portion 3C. Thus, the reception chamber 3 and the waveguide 27 are connected. Incidentally, an annular seal member 28 is provided between the flange portion 3C and the quartz sheet as the bottom surface 3B so as to keep airtightness between these two members.

Then, the magnetron 26 is connected to the other end of the waveguide 27 while keeping airtightness. The operation of the magnetron 26 is also controlled by the control unit 14. When the magnetron 26 is operated by the control unit 14, a microwave of 2.45 GHz is supplied into the reception chamber 3.

Next, in this embodiment, in the outer circumferential portion of the reception chamber 3, the rod-like permanent magnets 25 are disposed at even pitches in the circumferential direction. Here, the permanent magnets 25 adjacent to each other are disposed so that magnetic poles in contact with the outer circumferential surface of the reception chamber 3 are different from each other. Thus, in the third embodiment, a magnetic field is always formed near the inner circumferential portion of the reception chamber 3 close to these permanent magnets 25 by the permanent magnets 25.

Further, in this embodiment, an annular seal member 29 is attached to the outer circumferential portion of the lower surface of the cover 4. When the top opening of the reception chamber 3 is closed by the cover 4, the airtightness between the cover 4 and the top opening portion of the reception chamber 3 is kept by the seal member 29. In the third embodiment, a plasma generating unit for generating plasma is constituted by the waveguide 27 and the magnetron 26.

The other configuration is the same as that in the first embodiment, and detailed description thereof will be therefore omitted. [0015]

### ---(Description of Operation of Third Embodiment)

The surface of the PET container 2 is modified in the following manner by the modifying apparatus 1 configured thus according to the third embodiment.

That is, in the state where the cover 4 and the electrode 5 are retained in their rising limit positions by a not-shown elevating mechanism, the PET container 2 conveyed by a not-shown conveying mechanism is received in the reception chamber 3.

Next, the cover 4 is moved down to its falling limit position by the elevating mechanism. Thus, the electrode 5 is inserted into the PET container 2 through the opening portion 2A while the top opening portion of the reception chamber 3 is made airtight by the cover 4 (Fig. 5).

Because a magnetic field is formed in the inner circumferential portion of the reception chamber 3 by the plurality of permanent magnets 25, magnetic force by the permanent magnets 25 also acts on the PET container 2 received in the reception chamber 3.

Next, the control unit 14 opens the electromagnetic on-off valve 13 for a predetermined period of time. Thus, the reception chamber 3 is evacuated through the conduit 8 so that the pressure in the internal space of the reception chamber 3 becomes lower than the atmospheric pressure.

Next, in this state, the control unit 14 opens the electromagnetic on-off valve 21 provided in the conduit 16 for a predetermined period of time. Thus, argon gas is introduced into the internal space of the PET container 2 through the conduit 16. That is, the argon gas intervenes between the spaces inside and outside the PET container 2 in the reception chamber 3. Incidentally, the pressure in the reception chamber 3 at this time is not higher than the atmospheric pressure.

After that, the control unit 14 operates the magnetron 26 so that a microwave of 2.45 GHz is supplied from the magnetron 26 toward the bottom surface 3B of the reception chamber 3. Thus, the microwave is supplied into the reception chamber 3 so that plasma is generated in the argon gas in the reception chamber 3.

Further, in this state, the control unit 14 transmits an operating instruction to the DC high voltage power source 15 so that positive high voltage pulses are applied from the high voltage power source 15 to the electrode 5. Thus, ions of the plasma inside the PET container 2 are implanted into its interior side surface.

Incidentally, if necessary, after the electrode 5 is then moved up by a predetermined height relatively to the cover 4 by the elevating mechanism, an operating instruction may be transmitted again to the high voltage power source 15. Thus, ions are implanted into the interior side surface of the PET container 2 again.

Also in the third embodiment configured thus, it is possible to obtain functions and effects similar to those in the first embodiment. [0016]

### --- (Forth Embodiment)

Next, Fig. 7 shows a fourth embodiment of the invention. In brief, in this fourth embodiment, a waveguide 27 and a magnetron 26 are used in place of the coil 6, the matching circuit 17 and the high frequency power source 18 in the first embodiment.

That is, in the fourth embodiment, one end of the waveguide 27 is connected to the upper surface center portion of the cover 4 made of a conductive material. The top portion of the electrode 5 is designed to penetrate the waveguide 27 while keeping airtightness, so as to project upward. An end portion of the conduit 16 is connected to the top portion of the electrode 5. The magnetron 26 similar to that in the third embodiment is connected to the other end of the waveguide 27 while keeping airtightness. The operation of the magnetron 26 is also controlled by the control unit 14. When the magnetron 26 is operated by the control unit 14, a microwave is supplied toward the bottom surface 3B of the reception chamber 3.

In the fourth embodiment, the end portion of the waveguide 27 is connected to the cover 4. Therefore, a not-shown elevating mechanismmoves up the cover 4, the electrode 5 and the waveguide 27.

Further, in this embodiment, an annular seal member 29 is attached to the outer circumferential portion of the lower surface of the cover 4. When the top opening of the reception chamber 3 is closed by the cover 4, the airtightness between the cover 4 and the top opening portion of the reception chamber 3 is kept by the seal member 29. In the fourth embodiment, a plasma generating unit for generating plasma is constituted by the waveguide 27 and the magnetron 26.

The other configuration is the same as that in the first embodiment, and detailed description thereof will be therefore omitted. [0017]

### ---(Description of Operation of Fourth Embodiment)

The surface of the PET container 2 is modified in the following manner by the modifying apparatus 1 configured thus according to the fourth embodiment.

That is, in the state where the cover 4, the electrode 5 and the waveguide 27 are retained in their rising limit positions by a not-shown elevating mechanism, the PET container 2 conveyed by a not-shown conveying mechanism is received in the reception chamber 3.

Next, the cover 4 and so on are moved down to their falling limit positions by the elevating mechanism. Thus, the electrode 5 is inserted into the PET container 2 through the opening portion 2A while the top opening portion of the reception chamber 3 is made airtight by the cover 4 (Fig. 7).

At the same time, the control unit 14 switches the power source for the solenoid coil 7 so as to make a current flow into the solenoid coil 7 to thereby excite the solenoid coil 7. Thus, a magnetic field is formed in the reception chamber 3.

Next, the control unit 14 opens the electromagnetic on-off valve 13 for a predetermined period of time. Thus, the reception chamber 3 is evacuated through the conduit 8 so that the pressure in the internal space of the reception chamber 3 becomes lower than the atmospheric pressure.

Next, in this state, the control unit 14 opens the electromagnetic on-off valve 21 provided in the conduit 16 for a predetermined period of time. Thus, argon gas is introduced into the internal space of the PET container 2 through the conduit 16. That is, the argon gas intervenes between the spaces inside and outside the PET container 2 in the reception chamber 3. Incidentally, the pressure in the reception chamber 3 at this time is not higher than the atmospheric pressure.

After that, the control unit 14 operates the magnetron 26 so that a microwave is supplied from the magnetron 26 toward the cover 4. Thus, plasma is generated in the argon gas in the reception chamber 3.

Further, in this state, the control unit 14 transmits an operating instruction to the DC high voltage power source 15 so that positive high voltage pulses are applied from the high voltage power source 15 to the electrode 5. Thus, ions in the plasma on the interior side of the PET container 2 are implanted into the PET container 2 from its interior side surface.
Incidentally, if necessary, after the electrode 5 is then moved up by a predetermined height relatively to the cover 4 by the elevating mechanism, an operating instruction may be transmitted again to the high voltage power source 15. Thus, ions are implanted into the interior side surface of the PET container 2 again.

Also in the fourth embodiment configured thus, it is possible to obtain functions and effects similar to those in the first embodiment.

### --- (Fifth Embodiment)

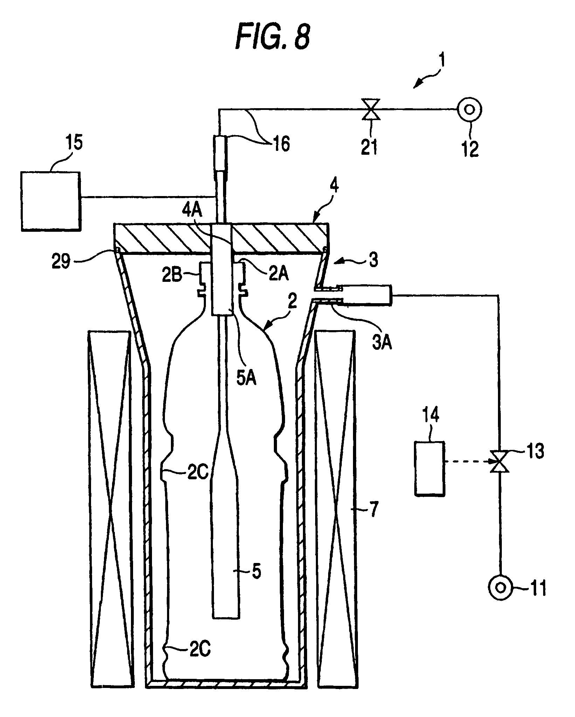

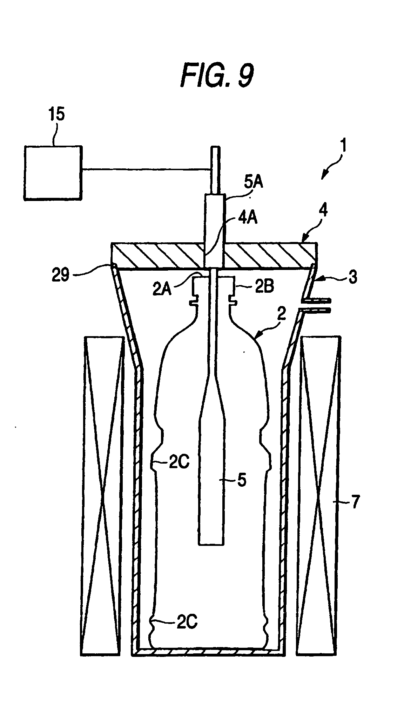

Next, Figs. 8 and 9 show a fifth embodiment of the invention. In the fifth embodiment, the coil 6, the matching circuit 17 and the high frequency power source 18 in the first embodiment are therefore omitted. The other configuration is the same as that in the first embodiment, and detailed description thereof will be omitted. In the fifth embodiment, the high voltage power source 15 is also used as a plasma generating unit for generating plasma. In the fifth embodiment, the surface of the PET container 2 is modified in the following manner.

That is, in the state where the cover 4 and the electrode 5 are retained in their rising limit positions by a not-shown elevating mechanism, the PET container 2 conveyed by a not-shown conveying mechanism is received in the reception chamber 3.

Next, the cover 4 is moved down to its falling limit position by the elevating mechanism. Thus, the electrode 5 is inserted into the PET container 2 through the opening portion 2A while the top opening portion of the reception chamber 3 is made airtight by the cover 4 (Fig. 8).

At the same time, the control unit 14 switches the power source for the solenoid coil 7 so as to make a current flow into the solenoid coil 7 to thereby excite the solenoid coil 7. Thus, a magnetic field is formed in the reception chamber 3.

Next, the control unit 14 opens the electromagnetic on-off valve 13 for a predetermined period of time. Thus, the reception chamber 3 is evacuated through the conduit 8 so that the pressure in the internal space of the reception chamber 3 becomes lower than the atmospheric pressure.

Next, in this state, the control unit 14 opens the electromagnetic on-off valve 21 provided in the conduit 16 for a predetermined period of time. Thus, argon gas is introduced into the internal space of the PET container 2 through the conduit 16. That is, the argon gas intervenes between the spaces inside and outside the PET container 2 in the reception chamber 3. Incidentally, the pressure in the reception chamber 3 at this time is lower than the atmospheric pressure.

After that, the control unit 14 transmits an operating instruction to the DC high voltage power source 15 so that positive high voltage pulses are applied from the high voltage power source 15 to the electrode 5. Thus, at the same time that plasma is generated on the interior side of the PET container 2, ions in the generated plasma are implanted into the PET container 2 from its interior side surface. As a result, the interior side surface of the PET container 2 is modified into DLC.

Incidentally, if necessary, after the electrode 5 is then moved up by a predetermined height relatively to the cover 4 by the elevating mechanism, an operating instruction may be transmitted again to the high voltage power source 15. Thus, as soon as plasma is generated on the interior side of the PET container 2 again, ions are implanted into the interior side surface of the PET container 2 again.

Also in the fifth embodiment configured thus, it is possible to obtain functions and effects similar to those in the first embodiment. [0019]

### --- (Sixth Embodiment)

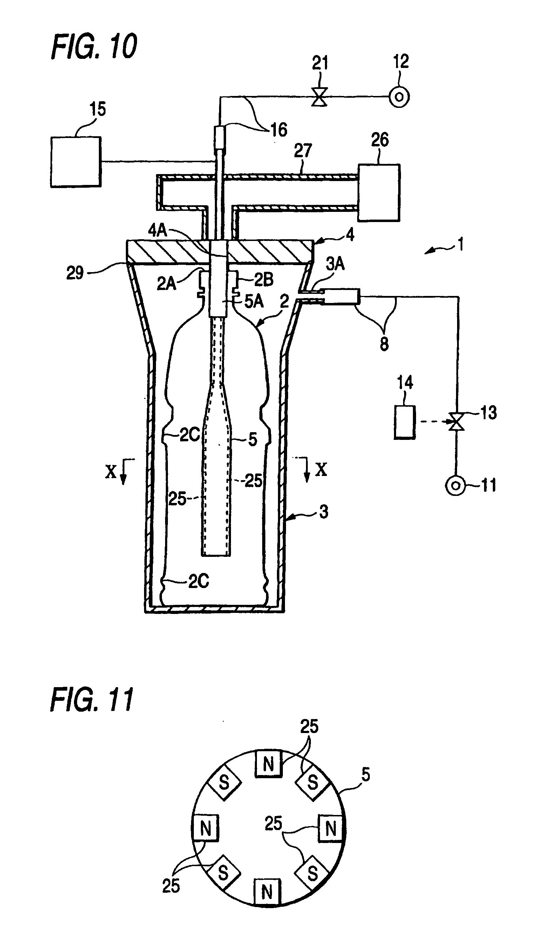

Next, Figs. 10 and 11 show a sixth embodiment of the invention. In the sixth embodiment, the solenoid coil 7 in the fourth embodiment shown in Fig. 7 is omitted, and in place of the solenoid coil 7, a plurality of permanent magnets 25 are provided.

That is, in the sixth embodiment, in the inner circumferential portion of the electrode 5 lower than the support portion 5A, rod-like permanent magnets 25 are disposed at even pitches in the circumferential direction. As shown in Fig. 11, the permanent magnets 25 adjacent to each other are disposed so that the positions of magnetic poles in contact with the inner circumferential surface of the electrode 5 are different from each other. Thus, in the sixth embodiment, a magnetic field is always formed in the electrode 5 itself by the plurality of permanent magnets 25. The other configuration is the same as that in the fourth embodiment shown in Fig. 7, and detailed description thereof will be therefore omitted.

### ---(Description of Operation of Sixth Embodiment)

The surface of the PET container 2 is modified in the following manner by the modifying apparatus 1 configured thus according to the sixth embodiment.

That is, in the state where the cover 4, the electrode 5 and the waveguide 27 are retained in their rising limit positions by a not-shown elevating mechanism, the PET container 2 conveyed by a not-shown conveying mechanism is received in the reception chamber 3.

Next, the cover 4 and so on are moved down to their falling limit positions by the elevating mechanism. Thus, the electrode 5 is inserted into the PET container 2 through the opening portion 2A while the top opening portion of the reception chamber 3 is made airtight by the cover 4 (Fig. 10).

By the plurality of permanent magnets 25, a magnetic field is formed in the electrode 5 inserted into the reception chamber 3.

After that, the control unit 14 opens the electromagnetic on-off valve 13 for a predetermined period of time. Thus, the reception chamber 3 is evacuated through the conduit 8 so that the pressure in the internal space of the reception chamber 3 becomes lower than the atmospheric pressure.

Next, in this state, the control unit 14 opens the electromagnetic on-off valve 21 provided in the conduit 16 for a predetermined period of time. Thus, argon gas is introduced into the internal space of the PET container 2 through the conduit 16. That is, the argon gas intervenes between the spaces inside and outside the PET container 2 in the reception chamber 3. Incidentally, the pressure in the reception chamber 3 at this time is not higher than the atmospheric pressure.

After that, the control unit 14 operates the magnetron 26 so that a microwave is supplied from the magnetron 26 toward the cover 4. Thus, plasma is generated in the argon gas in the reception chamber 3.

Further, in this state, the control unit 14 transmits an operating instruction to the DC high voltage power source 15 so that positive high voltage pulses are applied from the high voltage power source 15 to the electrode 5. Thus, ions in the plasma on the interior side of the PET container 2 are implanted into the PET container 2 from its interior side surface.

Incidentally, after the electrode 5 is then moved up by a height equal to the vertical length of the support portion 5A relatively to the cover 4 by the elevating mechanism, an operating instruction may be transmitted again to the high voltage power source 15. Thus, ions are implanted into the PET container 2 from its interior side surface again.

Also in the sixth embodiment configured thus, it is possible to obtain functions and effects similar to those in each of the previously described embodiments.

As has been described above, according to the invention, it is possible to obtain an effect that the surface layer of a container made of a polymeric compound can be modified into a material that is not permeable by carbon dioxide gas and oxygen or into a material that is hard to be permeated by carbon dioxide gas and oxygen.

## Claims

1. A method for modifying a surface of a container (2) made of a polymeric compound containing carbon, so as to modify a surface layer of said container into a material that is not permeable by carbon dioxide gas and oxygen or a material that is hard to be permeated by carbon dioxide gas and oxygen, wherein
ions are generated by a plasma inside of said container (2),
**characterized in that**
the surface modfication (22) is achieved by implanting the ions into the already existing surface layer of the container (2), whereby the ions are implanted by applying high-voltage pulses to an electrode (5) disposed inside the container (2).

2. A method for modifying a surface of a container (2) made of a polymeric compound according to claim 1, wherein the high voltage pulses applied to the electrode (5) are positive.

3. A method for modifying a surface of a container (2) made of a polymeric compound according to claim 1, wherein said container (2) made of a polymeric compound is one of a container made of polyethylene terephthalate and a container made of synthetic resin.

4. An apparatus for modifying a surface of a container (2) made of a polymeric compound comprising:
a reception chamber (3) adapted for receiving said container while keeping air tightness,
a vacuum pump (11) for evacuating said reception chamber (3); and
**characterized by**
the presence of both,
a plasma generating unit (6,17,18;26,27) in said reception chamber (3) as a means of generating plasma;
and an electrode (5) adapted for being inserted into said container (2) received in said reception chamber (3), together with a high voltage power source (15) for applying high voltage pulses to said electrode (5), as a means of implanting ions;
wherein the interior side surface layer of said container (2) received in said reception chamber (3) is modified into a material that is not permeable by carbon dioxide gas and oxygen or a material that is hard to be permeated by carbon dioxide gas and oxygen.

5. An apparatus for modifying a surface of a container (2) made of a polymeric compound according to claim 4, further comprising a magnetic field generating unit for generating a magnetic field in said reception chamber (3).

6. An apparatus for modifying a surface of a container (2) made of a polymeric compound according to claim 5, further comprising a gas supply source (12) fore supplying gas into said reception chamber (3).

7. An apparatus for modifying a surface of a container (2) made of a polymeric compound according to claim 5, said plasma generating unit including:
a coil (6) provided in an inner circumferential portion of said reception chamber 3; and
a high frequency power source (18) for applying a high frequency current to said coil through a matching circuit (17).

8. An apparatus for modifying a surface of a container (2) made of a polymeric compound according to claim 5, said plasma generating unit including:
a magnetron (26) for supplying a microwave into said reception chamber (3) through a waveguide (27).

9. An apparatus for modifying a surface of a container (2) made of a polymeric compound according to claim 5, wherein said magnetic generating unit includes one of a solenoid coil (7) provided to surround said reception chamber (3) and a plurality of permanent magnets (25) disposed to surround said reception chamber (3).

10. An apparatus for modifying a surface of a container (2) made of a polymeric compound according to claim 4, wherein said high voltage power source (12) applies positive high voltage pulses to said electrode (5).

11. An apparatus for modifying a surface of a container (2) made of a polymeric compound according to claim 4, wherein said container (2) made of a polymeric compound is one of a container (2) made of polyethylene terephthalate and a container made of synthetic resin.

## Patentansprüche

1. Verfahren zum Modifizieren einer Oberfläche eines Behälters (2), der aus einer Polymerverbindung besteht, die Kohlenstoff enthält, um so eine Oberflächenschicht des Behälters zu einem Material, das für Kohlendioxidgas und Sauerstoff nicht durchlässig ist, oder zu einem Material, das für Kohlendioxidgas und Sauerstoff schwer durchlässig ist, zu modifizieren wobei
Ionen durch ein Plasma im Inneren des Behälters (2) erzeugt werden,
**dadurch gekennzeichnet, dass**:
die Oberflächenmodifikation (22) erreicht wird, indem die Ionen in die bereits vorhandene Oberflächenschicht des Behälters (2) implantiert werden, wobei die Ionen implantiert werden, indem Hochspannungsimpulse an eine Elektrode (5) angelegt werden, die im Inneren des Behälters (2) angeordnet ist.

2. Verfahren zum Modifizieren einer Oberfläche eines Behälters (2), der aus einer Polymerverbindung besteht, nach Anspruch 1, wobei die Hochspannungsimpulse, die an die Elektrode (5) angelegt werden, positiv sind.

3. Verfahren zum Modifizieren einer Oberfläche eines Behälters (2), der aus einer Polymerverbindung besteht, nach Anspruch 1, wobei der Behälter (2), der aus einer Polymerverbindung besteht, ein Behälter ist, der aus Polyethylenterephthalat besteht, oder ein Behälter ist, der aus Kunstharz besteht.

4. Vorrichtung zum Modifizieren einer Oberfläche eines Behälters (2), der aus einer Polymerverbindung besteht, die umfasst:
eine Aufnahmekammer (3), die so eingerichtet ist, dass sie den Behälter aufnimmt und dabei Luftdichtigkeit aufrechterhält,
eine Vakuumpumpe (11), zum Auspumpen der Aufnahmekammer (3); und
**gekennzeichnet durch**
das Vorhandensein sowohl einer Plasmaerzeugungseinheit (6, 17, 18; 26, 27) in der Aufnahmekammer (3) als einer Einrichtung zum Erzeugen von Plasma;
als auch einer Elektrode (5), die so eingerichtet ist, dass sie in den Behälter (2), der in der Aufnahmekammer (3) aufgenommen ist, zusammen mit einer Hochspannungs-Energiequelle (15) zum Anlegen von Hochspannungsimpulsen an die Elektrode (5) als eine Einrichtung zum Implantieren von Ionen eingeführt wird;
wobei die Oberflächenschicht an der Innenseite des Behälters (2), der in der Aufnahmekammer (3) aufgenommen ist, zu einem Material, das für Kohlendioxidgas und Sauerstoff nicht durchlässig ist, oder zu einem Material, das für Kohlendioxidgas und Sauerstoff schwer durchlässig ist, modifiziert wird.

5. Vorrichtung zum Modifizieren einer Oberfläche eines Behälters (2), der aus einer Polymerverbindung besteht, nach Anspruch 4, die des Weiteren eine Magnetfeld-Erzeugungseinheit zum Erzeugen eines Magnetfelds in der Aufnahmekammer (3) umfasst.

6. Vorrichtung zum Modifizieren einer Oberfläche eines Behälters (2), der aus einer Polymerverbindung besteht, nach Anspruch 5, die des Weiteren eine Gaszuführquelle (12) zum Zuführen von Gas in die Aufnahmekammer (3) umfasst.

7. Vorrichtung zum Modifizieren einer Oberfläche eines Behälters (2), der aus einer Polymerverbindung besteht, nach Anspruch 5, wobei die Plasmaerzeugungseinheit enthält:
eine Wicklung (6), die in einem Innenumfangsabschnitt der Aufnahmekammer (3) vorhanden ist; und
eine Hochfrequenz-Energiequelle (18), zum Anlegen eines Hochfrequenzstroms an die Wicklung eine Anpassungsschaltung (17) anlegt.

8. Vorrichtung zum Modifizieren einer Oberfläche eines Behälters (2), der aus einer Polymerverbindung besteht, nach Anspruch 5, wobei die Plasmaerzeugungseinheit enthält:
ein Magnetron (26) zum Einleiten von Mikrowellen in die Aufnahmekammer (3) über einen Wellenleiter (27).

9. Vorrichtung zum Modifizieren einer Oberfläche eines Behälters (2), der aus einer Polymerverbindung besteht, nach Anspruch 5, wobei die Magnetfeld-Erzeugungseinheit eine Elektromagnetwicklung (7), die so vorhanden ist, dass sie die Aufnahmekammer (3) umgibt, oder eine Vielzahl von Permanentmagneten (25) enthält, die so angeordnet sind, dass sie die Aufnahmekammer (3) umgeben.

10. Vorrichtung zum Modifizieren einer Oberfläche eines Behälters (2), der aus einer Polymerverbindung besteht, nach Anspruch 4, wobei die Hochspannungs-Energiequelle (12) positive Hochspannungsimpulse an die Elektrode (5) anlegt.

11. Vorrichtung zum Modifizieren einer Oberfläche eines Behälters (2), der aus einer Polymerverbindung besteht, nach Anspruch 4, wobei der Behälter (2), der aus einer Polymerverbindung besteht, ein Behälter (2) ist, der aus Polyethylenterephthalat besteht, oder ein Behälter ist , der aus Kunstharz besteht.

## Revendications

1. Procédé pour modifier une surface d'un récipient (2) fait d'un composé polymère contenant du carbone, de façon à modifier une couche de surface dudit récipient en un matériau qui n'est pas perméable au dioxyde de carbone gazeux ou à l'oxygène ou en un matériau que le dioxyde de carbone gazeux et l'oxygène traversent difficilement par perméation, dans lequel
des ions sont générés par un plasma à l'intérieur dudit récipient (2),
**caractérisé en ce que**
la modification de surface (22) est réalisée par implantation des ions dans la couche de surface déjà existante du récipient (2), en conséquence de quoi les ions sont implantés par application d'impulsions haute tension à une électrode (5) disposée à l'intérieur du récipient (2).

2. Procédé pour modifier une surface d'un récipient (2) fait d'un composé polymère selon la revendication 1, dans lequel les impulsions haute tension appliquées à l'électrode (5) sont positives.

3. Procédé pour modifier une surface d'un récipient (2) fait d'un composé polymère selon la revendication 1, dans lequel ledit récipient (2) fait d'un composé polymère est l'un parmi un récipient fait de poly(téréphtalate d'éthylène) et un récipient fait de résine synthétique.

4. Dispositif pour modifier une surface d'un récipient (2) fait d'un composé polymère, comprenant :
une chambre de réception (3) adaptée pour recevoir ledit récipient tout en maintenant une étanchéité à l'air,
une pompe à vide (11) pour évacuer ladite chambre de réception (3) ; et
**caractérisé par**
la présence à la fois
d'une unité génératrice de plasma (6, 17, 18 ; 26, 27) dans ladite chambre de réception (3) servant de moyen de génération de plasma ;
et d'une électrode (5) adaptée pour être insérée dans ledit récipient (2) reçu dans ladite chambre de réception (3), conjointement avec une source d'énergie haute tension (15) pour appliquer des impulsions haute tension à ladite électrode (5), servant de moyen d'implantation d'ions ;
dans lequel la couche de surface latérale intérieure dudit récipient (2) reçu dans ladite chambre de réception (3) est modifiée en un matériau qui n'est pas perméable au dioxyde de carbone gazeux ou à l'oxygène ou en un matériau que le dioxyde de carbone gazeux et l'oxygène traversent difficilement par perméation.

5. Dispositif pour modifier une surface d'un récipient (2) fait d'un composé polymère selon la revendication 4, comprenant en outre une unité génératrice de champ magnétique pour générer un champ magnétique dans ladite chambre de réception (3).

6. Dispositif pour modifier une surface d'un récipient (2) fait d'un composé polymère selon la revendication 5, comprenant en outre une source de délivrance de gaz (12) pour délivrer un gaz dans ladite chambre de réception (3).

7. Dispositif pour modifier une surface d'un récipient (2) fait d'un composé polymère selon la revendication 5, ladite unité génératrice de plasma contenant :
un enroulement (6) disposé dans une partie circonférentielle intérieure de ladite chambre de réception 3 ; et
une source d'énergie haute fréquence (18) pour appliquer un courant haute fréquence audit enroulement par l'intermédiaire d'un circuit d'adaptation (17).

8. Dispositif pour modifier une surface d'un récipient (2) fait d'un composé polymère selon la revendication 5, ladite unité génératrice de plasma contenant :
un magnétron (26) pour délivrer une micro-onde dans ladite chambre de réception (3) par l'intermédiaire d'un guide d'onde (27).

9. Dispositif pour modifier une surface d'un récipient (2) fait d'un composé polymère selon la revendication 5, ladite unité génératrice magnétique contient l'un parmi une bobine de solénoïde (7) disposée de façon à entourer ladite chambre de réception (3) et une pluralité d'aimants permanents (25) disposés de façon à entourer ladite chambre de réception (3).

10. Dispositif pour modifier une surface d'un récipient (2) fait d'un composé polymère selon la revendication 4, dans lequel ladite source d'énergie haute tension (12) applique des impulsions haute tension positives à ladite électrode (5).

11. Dispositif pour modifier une surface d'un récipient (2) fait d'un composé polymère selon la revendication 4, dans lequel ledit récipient (2) fait d'un composé polymère est l'un parmi un récipient (2) fait de poly(téréphtalate d'éthylène) et un récipient fait de résine synthétique.
